# EUROPÄISCHE PATENTSCHRIFT

(11) **EP 1 122 826 B1**
(45) Veröffentlichungstag und Bekanntmachung des Hinweises auf die Patenterteilung: **06.05.2004**
(21) Anmeldenummer: 01101210.1
(22) Anmeldetag: 18.01.2001
(51) Int. Cl.: H01R 13/03, H05K 7/12, B29C 45/16

(54) **Sicherungsträger**
Fuse carrier
Porte-fusible

(30) Priorität: 04.02.2000 DE 10005025
(43) Veröffentlichungstag der Anmeldung: 08.08.2001
(73) Patentinhaber: ABB PATENT GmbH, 68526 Ladenburg (DE)
(72) Erfinder: Vogt, Friedrich, 58579 Schalksmühle (DE); Zapp, Robert, 58579 Schalksmühle (DE); Neumann, Wolfgang, 58849 Herscheid (DE); Schmidt, Karsten, 42477 Radevormwald (DE)
(74) Vertreter: Miller, Toivo

(56) Entgegenhaltungen:
- DE-A- 3 610 676
- DE-A- 19 822 990
- US-A- 4 411 486

## Beschreibung

Die Erfindung bezieht sich auf einen Sicherungsträger gemäß dem Oberbegriff des Anspruchs 1. Die Erfindung kann beispielsweise bei Dimmern verwendet werden.

In elektrischen/elektronischen Installationsgeräten, wie Unterputz-Dimmereinsätzen werden sogenannte Geräteschutzsicherungen nach DIN EN 60127-2, Klassifikation VDE 0820 Teil 2 eingesetzt. Diese Sicherungen müssen mit den entsprechenden Schaltungsträgern, d. h. Grundleiterplatten, kontaktiert werden. Erzielt wird diese Kontaktierung mittels metallener Kontaktteile, die auf der Grundleiterplatte bestückt und anschließend verlötet werden. Die Geräteschutzsicherungen können waagerecht oder senkrecht zur Grundleiterplatte angeordnet sein. Zur sicheren Positionierung und um ein einfaches Auswechseln der Sicherungen zu ermöglichen, werden meist Kunststoffgehäuse zur Halterung der Sicherungen eingesetzt zum Beispiel wie im U.S. Patent Nr. 4 411 486. Diese Kunststoffgehäuse mit eingelegter Sicherung werden durch eine entsprechende Öffnung in den Unterputzeinsatz eingeführt und verrastet (bei waagerechter bzw. "liegender", paralleler Anordnung bezüglich der Grundleiterplatte) oder mittels eines Bajonettverschlusses (bei senkrechter bzw. "stehender" Anordnung bezüglich der Grundleiterplatte) arretiert.

Nachteile dieser allgemein bekannten Sicherungsträger sind die relativ hohe Teileanzahl zur Kontaktierung und Halterung der Sicherung sowie die erforderlichen Fertigungsschritte, wie Montieren, Bestücken, Löten. Bei der waagerechten Anordnung der Sicherung sind in der Regel drei Teile erforderlich: Zwei Kontaktteile aus Metall, die auf der Grundleiterplatte bestückt und anschließend verlötet werden und ein Kunststoffgehäuse, in welches die Sicherung eingeclipst wird. Das mit der Sicherung bestückte Kunststoffgehäuse wird durch eine Öffnung im Installationsgerät zu den Kontaktteilen geführt. Dort wird die Sicherung in die Kontaktteile eingeclipst. Bei der senkrechten Anordnung der Sicherung sind in der Regel vier Teile erforderlich: Zwei auf der Grundleiterplatte bestückte und dort verlötete metallene Kontaktteile sowie eine Kunststoffhülse mit montiertem metallenem Kontaktteil.

Der Erfindung liegt die Aufgabe zugrunde, einen Sicherungsträger der eingangs genannten Art mit vereinfachtem Aufbau anzugeben.

Diese Aufgabe wird in Verbindung mit den Merkmalen des Oberbegriffes erfindungsgemäß durch die im Kennzeichen des Anspruchs 1 angegebenen Merkmale gelöst.

Die mit der Erfindung erzielbaren Vorteile bestehen insbesondere darin, daß der Sicherungsträger aus einem einzigen Einzelteil besteht, sehr wenig Fertigungsschritte benötigt und aufgrund der wenigen notwendigen Montageschritte sehr montagefreundlich ist. Dies reduziert die Investitionskosten (beispielsweise die Kosten für Werkzeuge zur Herstellung der Einzelteile) und die Montagekosten. Betrachtet man das System Sicherungsträger/Grundleiterplatte, so handelt es sich um zwei Einzelteile. Vorteilhaft sind keine Bestückungs- und Lötvorgänge erforderlich.

Weitere Vorteile sind aus der nachstehenden Beschreibung ersichtlich.

Vorteilhafte Ausgestaltungen der Erfindung sind in den Unteransprüchen gekennzeichnet.

Die Erfindung wird nachstehend anhand der in der Zeichnung dargestellten Ausführungsbeispiele erläutert. Es zeigen:
- Fig.1: einen Sicherungsträger gemäß erster Ausführungsform,
- Fig. 2: eine zum Sicherungsträger erster Ausführungsform korrespondierende Grundleiterplatte,
- Fig. 3: die aus galvanisierbarem Kunststoff gebildete Komponente des Sicherungsträgers erster Ausführungsform (linke Abbildung) sowie der komplette Sicherungsträger in perspektivischer Darstellung (rechte Abbildung),
- Fig. 4: eine Grundleiterplatte mit optimierten elektrischen Kontaktflächen,
- Fig. 5: einen Sicherungsträger gemäß zweiter Ausführungsform,
- Fig. 6: eine Seitenansicht des Sicherungsträgers gemäß zweiter Ausführungsform,
- Fig. 7: die einzelnen Schritte zur Herstellung des Sicherungsträgers,
- Fig. 8: die einzelnen Schritte zur Herstellung einer Grundleiterplatte.

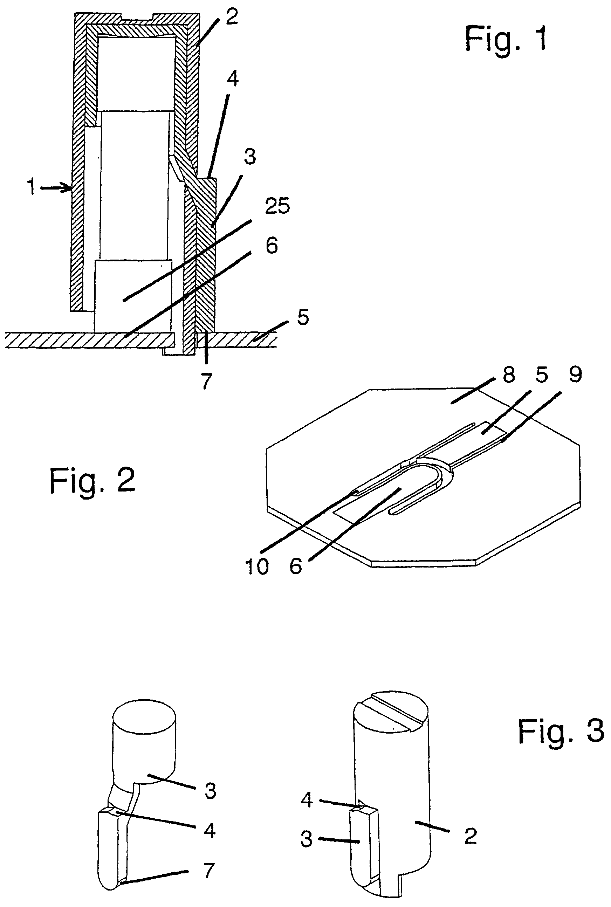

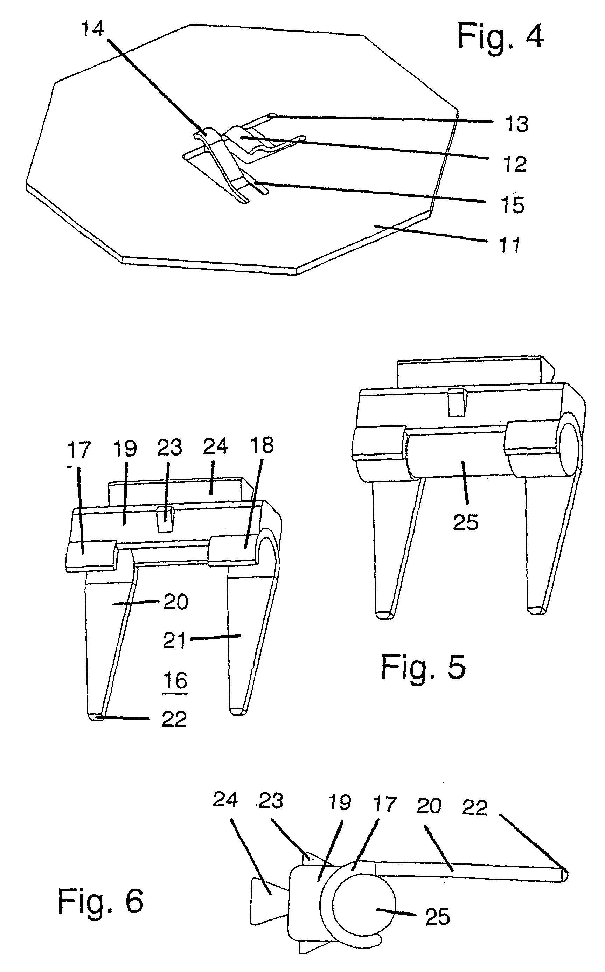

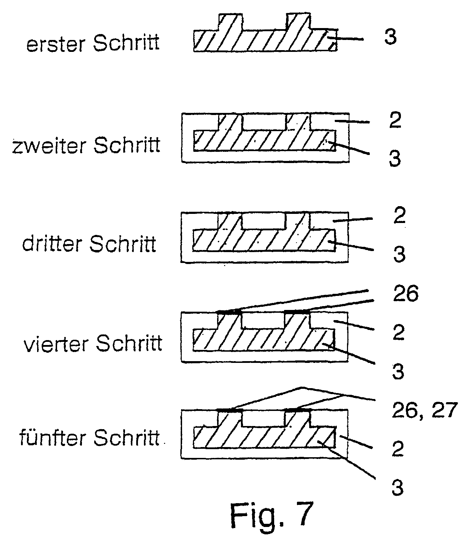

In Fig. 1 ist ein Sicherungsträger gemäß erster Ausführungsform dargestellt. Dieser Sicherungsträger betrifft die "stehende" Variante und bietet vorteilhaft eine sehr gute Raumausnutzung im begrenzten Raum eines Unterputzeinsatzes eines Dimmers. Der Sicherungsträger 1 weist eine eine eingelegte zylinderförmige Sicherung 25 hülsenförmig umfassende Formgebung auf, ist aus zwei unterschiedlichen Komponenten, nämlich einer Komponente 2 aus nicht galvanisierbarem Kunststoff und einer Komponente 3 aus galvanisierbarem Kunststoff aufgebaut und steht in Kontakt mit einer Grundleiterplatte (siehe Ziffer 8 gemäß Fig. 2 und Ziffer 11 in Fig. 4). Die Fertigung erfolgt vorzugsweise in der unter Fig. 7 näher erläuterten MID-Technik (Molded Interconnect Devices).

Dabei erfolgt eine Kontaktierung (Seitenkontakt) zwischen einer elektrischen Kontaktfläche 5 der Grundleiterplatte und einer elektrisch leitenden Kontaktfläche 7 der Komponente 3 aus galvanisierbarem Kunststoff sowie zwischen einer elektrischen Fußkontaktfläche 6 der Grundleiterplatte und einem ersten Kontakt der "stehend" auf der Grundleiterplatte angeordneten Sicherung 25. Ein zweiter Kontakt der Sicherung 25 wird von einer elektrisch leitenden Kontaktfläche der Komponente 3 aus galvanisierbarem Kunststoff hülsenförmig umschlossen und kontaktiert, so daß eine elektrische Verbindung zur Kontaktfläche 7 bewirkt wird.

Die Grundleiterplatte ist mit einer Ausnehmung versehen, in welche die Komponente 2 aus nicht galvanisierbarem Kunststoff eingreift. Dies dient vorteilhaft dazu, die Luft- und Kriechstrecken (Kurzschluß, Potentialüberschlag) zwischen den beiden Sicherungskontaktflächen zu vergrößern. Zur Anpressung des Sicherungsträgers gegen die Grundleiterplatte bildet die Komponente 3 aus galvanisierbarem Kunststoff einen Anschlag 4 für den Eingriff eines Bajonettverschlusses.

Zur Befestigung wird der Sicherungsträger mittels des Bajonettverschlusses zwischen der federnden Leiterplatte und einem das Gerät umgebenden Gehäuse eingeklemmt.

In Fig. 2 ist eine zum Sicherungsträger erster Ausführungsform korrespondierende Grundleiterplatte dargestellt, welche vorzugsweise ebenfalls in MID-Technik (Molded Interconnect Devices) hergestellt ist. Es ist zu erkennen, daß sowohl die elektrische Kontaktfläche 5 (Seitenkontakt) als auch die gegenüberliegende Fußkontaktfläche 6 auf drei Seiten mit Schlitzen 9 bzw. 10 versehen sind, so daß hierdurch gegenüber der Grundleiterplatte 8 federnde elektrische Kontakte gebildet werden. Der zur Federung der Kontaktflächen eingebrachte Schlitz zwischen den beiden Kontaktflächen 5, 6 ist gleichzeitig die vorstehend erwähnte Ausnehmung für den Eingriff des Sicherungsträgers mit der Komponente 2 aus nicht galvanisierbarem Kunststoff.

In Fig. 3 ist in der linken Abbildung die aus galvanisierbarem Kunststoff gebildete Komponente 3 des Sicherungsträgers erster Ausführungsform dargestellt. Diese Komponente wird im wesentlichen durch den zum Eingriff eines Kontaktes (Kontakthülse) einer Sicherung 25 geeigneten Abschnitt und den daran einstückig sich anschließenden Abschnitt mit der Kontaktfläche 7 und dem Anschlag 4 für einen Bajonettverschluß gebildet. In der rechten Abbildung der Fig. 3 ist der komplette Sicherungsträger in perspektivischer Darstellung dargestellt. Die Komponente 2 aus nicht galvanisierbarem Kunststoff umschließt die nach außen gerichtete Fläche der Komponente 3 aus galvanisierbarem Kunststoff fast vollständig, lediglich der seitliche Abschnitt mit dem Anschlag 4 für einen Bajonettverschluß durchbricht die Komponente 2. Zweckmäßig ist die Stirnseite des Sicherungsträgers mit einer zum Eingriff eines Werkzeuges (Schraubendrehers) geeigneten Nut versehen, wodurch eine Drehbewegung des Sicherungsträgers bewirkt werden kann, um eine Montage/Demontage des Sicherungsträgers auf der/von der Grundleiterplatte zu ermöglichen.

In Fig. 4 ist eine vorzugsweise in MID-Technik (Molded Interconnect Devices) gefertigte Grundleiterplatte mit optimierten elektrischen Kontaktflächen dargestellt. Bei dieser Grundleiterplatte 11 sind jeweils eine (bogenförmig) abgebogene federnde Kontaktfläche 12 bzw. Fußkontaktfläche 14 vorgesehen, wobei diese Kontaktflächen 12 bzw. 14 durch Schlitze 13 bzw. 15 von der Grundleiterplatte 11 abgegrenzt sind.

In Fig. 5 ist ein Sicherungsträger gemäß zweiter Ausführungsform dargestellt. Dieser Sicherungsträger 16 ist für "liegende", parallele Anordnung der Sicherung hinsichtlich einer Grundleiterplatte geeignet. Die linke Abbildung zeigt den Sicherungsträger 16 mit Komponenten 17, 18 aus galvanisierbarem Kunststoff, welche elektrische Kontaktflächen für die Sicherung bilden, mit Komponente 19 aus nicht galvanisierbarem Kunststoff und mit zwei Kontaktlaschen 20, 21, welche aus galvanisierbarem Kunststoff gebildet sind. Die Enden dieser Kontaktlaschen 20, 21 bilden Kontaktflächen 22 zur Grundleiterplatte. Die Komponente 19 aus nicht galvanisierbarem Kunststoff weist Rastkanten 23 und einen Griff 24 auf. Die Rastkanten 23 bewirken eine Arretierung des auf einer Grundleiterplatte montierten Sicherungsträgers 16, während der Griff eine einfache Demontage/Montage des Sicherungsträgers 16 von der Grundleiterplatte/auf die Grundleiterplatte ermöglicht.

Wie bereits aus der vorstehenden Beschreibung hervorgeht, ermöglichen die verlängerten Kontaktlaschen 20, 21 bzw. Kontaktstifte eine von der Grundleiterplatte distanzierte Montage des Sicherungsträgers 16 in einer vorgegebenen Entfernung von der Grundleiterplatte. Die elektrischen Kontaktflächen 22 der Kontaktlaschen 20, 21 drükken gegen federnde Kontaktflächen der Grundleiterplatte, wie sie beispielsweise in Fig. 4 prinzipiell skizziert sind.

Die rechte Abbildung der Fig. 5 zeigt den Sicherungsträger 16 mit eingelegter Sicherung 25.

In Fig. 6 ist eine Seitenansicht des Sicherungsträgers gemäß zweiter Ausführungsform dargestellt. Es sind die Komponente 19 aus nicht galvanisierbarem Kunststoff mit Rastkanten 23 und Griff 24, die Komponente 17 aus galvanisierbarem Kunststoff mit Kontaktlasche 20 und Kontaktfläche 22 und ein Kontakt der eingelegten Sicherung 25 zu erkennen.

In Fig. 7 sind die einzelnen Schritte zur Herstellung des Sicherungsträgers 1 dargestellt. Die Herstellung erfolgt vorzugsweise in MID-Technik (Molded Interconnect Devices) und zwar speziell in Zweikomponentenspritzguß-Technik. Dieses spezielle MID-Herstellungsverfahren ermöglicht eine hohe Gestaltungsfreiheit, eine Durchkontaktierung ohne zusätzliche Maßnahmen und eine hohe Flexibilität bezüglich des Schichtaufbaues, wobei die Effizienz des Herstellungsprozesses sehr hoch ist.

In einzelnen wird zur Herstellung des Sicherungsträgers in einem ersten Schritt die Komponente 3 aus einem galvanisierbarem Kunststoff gespritzt ("erster Schuß"). In einem zweiten Schritt erfolgt die teilweise Umhüllung der Komponente 3 mit der Komponente 2 aus einem nicht galvanisierbarem, elektrisch isolierendem Kunststoff ("zweiter Schuß"). Die Komponente 2 dient insbesondere zur Gewährleistung eines mechanisch robusten Aufbaus des Sicherungsträgers und zu einer elektrischen Isolierung des Sicherungsträgers zu diskreten elektrischen/elektronischen Bauelementen und zum Gehäuse bzw. weiteren Baukomponenten des elektrischen/elektronischen Gerätes.

In einem dritten Schritt erfolgt eine Oberflächenaktivierung der Komponente 3 aus dem galvanisierbarem Kunststoff. In einem vierten Schritt erfolgt eine Metallisierung der freiliegenden Bereiche der Komponente 3 aus dem galvanisierbarem Kunststoff durch Aufbringung einer ersten Metallschicht 26 (Grundmetallisierung). In einem fünften Schritt erfolgt eine Oberflächenveredelung durch Aufbringung einer zweiten Metallschicht 27 mit sehr guter elektrischer Leitfähigkeit auf die Grundmetallisierung zur Schaffung der elektrischen Kontaktflächen zur eingelegten Sicherung und zur Grundleiterplatte.

Die einzelnen Schritte zur Herstellung des Sicherungsträgers 16 laufen prinzipiell in gleicher Art und Weise ab.

Bei der Herstellung der Grundleiterplatte 8, 11 kommt vorzugsweise ebenfalls ein MID-Herstellungsverfahren zum Einsatz, wobei außer dem vorstehend erläuterte Zweikomponenten-Spritzgußverfahren ein Einkomponenten-Spritzgußverfahren, insbesondere das Heißprägeverfahren verwendbar ist. Es wird ein Kunststoff-Spritzgußteil 28 gefertigt, das mit Hilfe des Heißprägeverfahrens mit Leiterbahnen versehen wird, welche unter anderem die gewünschten elektrischen Kontaktflächen zur Kontaktierung der Sicherung bzw. des Sicherungsträgers bilden.

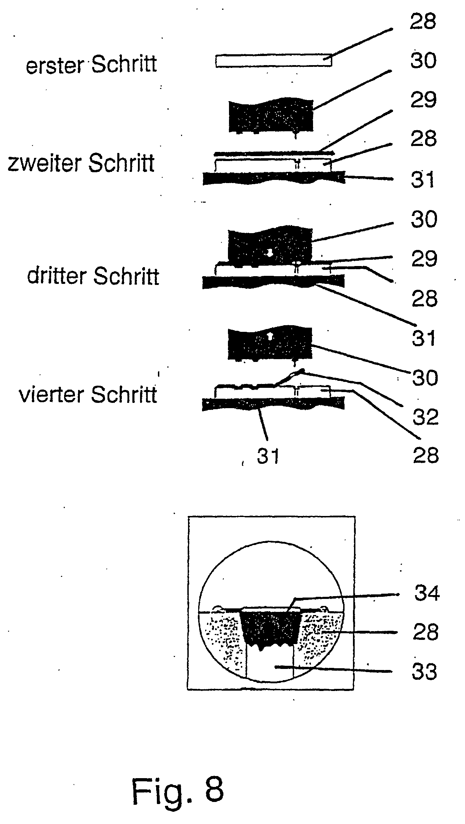

In Fig. 8 sind die einzelnen Schritte zur Herstellung einer Grundleiterplatte 8, 11 gemäß dem Heißprägeverfahren dargestellt. In einem ersten Schritt erfolgt die Fertigung des Kunststoff-Spritzgußteils 28. In einem zweiten Schritt wird eine elektrisch leitfähige Folie 29 auf das auf einem Tisch 31 und unterhalb eines Preßwerkzeuges 30 befindliche Kunststoff-Spritzgußteil 28 aufgelegt. In einem dritten Schritt erfolgt durch Aufdrücken des auf eine gewünschter Temperatur aufgeheizten Preßwerkzeuges 30 auf das Kunststoff-Spritzgußteil 28 mit Folie 29 das Prägen und Kleben in gewünschter Form. In einem vierten Schritt werden nicht aufgeprägte/aufgeklebte Abschnitte der Folie als Restfolie 32 vom Kunststoff-Spritzgußteil 28 entfernt.

Eventuell erforderliche Durchkontaktierungen 33 werden in einem sich anschließenden weiteren Schritt mit Leitpaste 34 aufgefüllt.

Prinzipiell könnte für die Grundleiterplatte 8, 11 auch eine herkömmliche Leiterplatte eingesetzt werden. Eine in MID-Technik hergestellte Grundleiterplatte besitzt jedoch den Vorteil, daß unterschiedliche Kunststoff-Materialien mit unterschiedlichen Federungseigenschaften verwendet werden können. Als Komponente aus galvanisierbarem Kunststoff (zur Bildung der Kontaktflächen für den Sicherungsträger und die Sicherung) kann ein Kunststoff mit guten Federungseigenschaften verwendet, während als Komponente aus nicht galvanisierbarem Kunststoff ein relativ hartes, nicht federndes Material eingesetzt werden kann. Eine in MID-Technik hergestellte Leiterplatte bietet den Vorteil, daß es durch das Spritzgießen und die damit verbundene Gestaltungsfreiheit möglich ist, die elektrischen Kontaktflächen zur verbesserten Stromübertragung optimal auszuformen, wie dies in Fig. 4 skizziert ist. Somit ist eine Anpassung an den jeweiligen speziellen Einsatzfall durch Anwendung der MID-Technik wesentlich einfacher als beim Einsatz einer Leiterplatte herkömmlicher Bauart.

## Patentansprüche

1. Sicherungsträger für ein elektrisches /elektronisches Installationsgerät, wobei eine Grundleiterplatte (8, 11) zur Kontaktierung einer Sicherung (25) dient, **dadurch gekennzeichnet,**
**dass** der Sicherungsträger (1, 16) aus zwei Hauptkomponenten aufgebaut ist, nämlich einer ersten Komponente (3, 17, 18) aus einem galvanisierbaren Kunststoff und einer zweiten Komponente (2, 19) aus einem nicht galvanisierbaren, elektrisch isolierenden Kunststoff, wobei die erste Komponente (3, 17, 18) in Verbindung mit mindestens einer aufgebrachten Metallschicht (26, 27) zur Bildung von elektrischen Kontaktflächen zur Kontaktierung der Sicherung (25) und der Grundleiterplatte (8, 11) dient und die zweite Komponente (2, 19) den mechanisch robusten Aufbau und die elektrische Isolierung des Sicherungsträgers (1, 16) gewährleistet und
**dass** die Grundleiterplatte (8, 11) ebenfalls aus zwei Hauptkomponenten aufgebaut ist, nämlich einer ersten Komponente aus einem galvanisierbaren Kunststoff und einer zweiten Komponente aus einem nicht galvanisierbaren, elektrisch isolierenden Kunststoff, wobei die erste Komponente in Verbindung mit mindestens einer aufgebrachten Metallschicht (26, 27) zur Bildung von elektrischen Kontaktflächen zur Kontaktierung der Sicherung (25) und des Sicherungsträgers (1, 16) dient und die zweite Komponente den mechanisch robusten Aufbau und die elektrische isolierung der Grundleiterplatte (8, 11) gewährleistet.

2. Sicherungsträger nach Anspruch 1, **dadurch gekennzeichnet, dass** als erste Komponente (3, 17, 18) ein federndes Kunststoff-Material Verwendung findet.

3. Sicherungsträger nach Anspruch 1 und/oder 2, **dadurch gekennzeichnet, dass** die elektrischen Kontaktflächen aus einer Grundmetallisierung und einer hierauf aufgebrachten elektrisch gut leitenden Schicht aufgebaut sind.

## Claims

1. Fuse carrier for an electrical/electronic installation device, a backplane PCB (8, 11) serving for the contacting of a fuse (25), **characterized**
**in that** the fuse carrier (1, 16) is constructed from two main components, that is a first component (3, 17, 18) made of an electroplatable plastic and a second component (2, 19) of a non-electroplatable, electrically insulating plastic, the first component (3, 17, 18) serving together with at least one applied metal layer (26, 27) for forming electrical contact areas for the contacting of the fuse (25) and the backplane PCB (8, 11), and the second component (2, 19) ensuring the mechanically robust construction and the electrical insulation of the fuse carrier (1, 16), and
**in that** the backplane PCB (8, 11) is likewise constructed from two main components, that is a first component made of an electroplatable plastic and a second component of a non-electroplatable, electrically insulating plastic, the first component serving together with at least one applied metal layer (26, 27) for forming electrical contact areas for the contacting of the fuse (25) and the fuse carrier (1, 16) and the second component ensuring the mechanically robust construction and the electrical insulation of the backplane PCB (8, 11).

2. Fuse carrier according to Claim 1, **characterized in that** a resilient plastic material is used as the first component (3, 17, 18).

3. Fuse carrier according to Claim 1 and/or 2, **characterized in that** the electrical contact areas are constructed by a base metallization and a layer with good electrical conduction applied thereto.

## Revendications

1. Porte-fusible pour un appareil d'installation électrique ou électronique, utilisant une carte de base (8, 11) pour établir le contact avec un fusible (25), **caractérisé**
**en ce que** le porte-fusible (1, 16) est fait de deux composants principaux, à savoir un premier composant (3, 17, 18) fait dans un plastique galvanisable et un second composant (2, 19) fait dans un plastique non galvanisable, électriquement isolant, le premier composant (3, 17, 18), en liaison avec au moins une couche métallique (26, 27) appliquée, servant à former des surfaces de contact électrique afin d'établir le contact avec le fusible (25) et la carte de base (8, 11) et le second composant (2, 19) assurant une construction mécaniquement robuste et l'isolation électrique du porte-fusible (1, 16), et
**en ce que** la carte de base (8, 11) est également fabriquée à l'aide de deux composants, à savoir un premier composant en plastique galvanisable et un second composant en plastique non galvanisable, électriquement isolant, le premier composant, en liaison avec au moins une couche métallique appliquée, servant à former des surfaces de contact électrique afin d'établir le contact avec le fusible (25) et le porte-fusible (1, 16) et le second composant assurant une construction mécaniquement robuste et l'isolation électrique de la carte de base (8, 11).

2. Porte-fusible selon la revendication 1, **caractérisé en ce que** l'on utilise pour le premier composant (3, 17,18) un matériau plastique élastique.

3. Porte-fusible selon la revendication 1 ou 2, **caractérisé en ce que** les surfaces de contact électrique sont composées d'une métallisation de base et d'une couche électriquement bonne conductrice appliquée sur celle-ci.
